Europäisches Patentamt

European Patent Office

Office européen des brevets

(11) Veröffentlichungsnummer : **0 414 305 B1**

(12) # EUROPÄISCHE PATENTSCHRIFT

(45) Veröffentlichungstag der Patentschrift :
**07.12.94 Patentblatt 94/49**

(51) Int. Cl.$^5$ : **H03D 13/00**

(21) Anmeldenummer : **90202200.3**

(22) Anmeldetag : **15.08.90**

(54) **Phasenvergleichsschaltung.**

(30) Priorität : **19.08.89 DE 3927381**

(43) Veröffentlichungstag der Anmeldung :
**27.02.91 Patentblatt 91/09**

(45) Bekanntmachung des Hinweises auf die
Patenterteilung :
**07.12.94 Patentblatt 94/49**

(84) Benannte Vertragsstaaten :
**DE FR GB**

(56) Entgegenhaltungen :
**EP-A- 0 344 495
GB-A- 2 140 993
PATENT ABSTRACTS OF JAPAN, Band 6, Nr.
16 (E-92)[894], 29. Januar 1982; & JP-A-56 136
053 (HITACHI SEISAKUSHO K.K.) 23-10-1981
PATENT ABSTRACTS OF JAPAN, Band 10, Nr.
192 (E-417)[2248], 5. Juli 1986; & JP-A-61 39 605
(TOSHIBA CORP.) 25-02-1986**

(73) Patentinhaber : **Philips Patentverwaltung
GmbH
Wendenstrasse 35c
D-20097 Hamburg (DE)**
(84) **DE**
Patentinhaber : **N.V. Philips'
Gloeilampenfabrieken
Groenewoudseweg 1
NL-5621 BA Eindhoven (NL)**
(84) **FR GB**

(72) Erfinder : **Janta, Dieter
Krupunder Stieg 31
D-2083 Halstenbek (DE)**
Erfinder : **Jansen, Winfried
Blütenweg 29
D-2087 Ellerbek (DE)**

(74) Vertreter : **von Laue, Hanns-Ulrich, Dipl.-Ing. et
al
Philips Patentverwaltung GmbH
Wendenstrasse 35c
D-20097 Hamburg (DE)**

EP 0 414 305 B1

## Beschreibung

Die Erfindung betrifft eine Phasenvergleichsschaltung, insbesondere für einen Phasenregelkreis (PLL) in einem Dekoder für Multiplexsignale, mit einer Doppel-Gegentakt-Mischstufe, der ein Sinussignal, insbesondere der Pilotton eines Multiplexsignals, sowie dieses Sinussignal in Gegenphase und ein Rechteck-Schaltsignal gleicher Schaltfrequenz zugeführt sind, welches insbesondere aus der Frequenz eines Phasenregelkreises abgeleitet ist.

Derartige Phasenvergleichsschaltungen sind insbesondere aus Stereo-Dekodern bekannt, in denen Stereo-Multiplexsignale, z.B. des UKW-Stereo-Rundfunks, dekodiert werden, in denen also die Signale für den linken und rechten Kanal gewonnen werden. Diese Dekoder weisen in der Regel eine Doppel-Gegentakt-Mischstufe auf, wobei einer der Gegentakt-Mischstufen das Pilottonsignal (19 KHz) zugeführt ist, während der anderen Gegentakt-Mischstufe das gleiche Signal, jedoch in Gegenphase zugeführt ist. Der Phasenvergleichsschaltung, die in solchen Dekodern Teil eines Phasenregelkreises (PLL) ist, wird eine Rechteck-Schaltspannung zugeführt, die aus der Frequenz eines spannungsgesteuerten Oszillators des Phasenregelkreises abgeleitet ist, und die bei eingerasteten Phasenregelkreis die gleiche Frequenz hat wie das Pilottonsignal.

Die Phasenvergleichsschaltung dient dabei dazu, den Phasenregelkreis, in dem ein spannungsgesteuerter Oszillator vorgesehen ist, so zu regeln, daß das Pilottonsignal und das Rechteckschaltsignal des Phasenregelkreises sich zueinander in einer Soll-Phasenlage befinden. Dies geschieht in der Weise, daß laufend während zu den Halbperioden des Schaltsignals synchronen Zeitintervallen ein zu dem Sinussignal proportionales Ausgangssignal geliefert wird. In einer nachfolgenden Tiefpaßschaltung wird eine Integration dieses Signals vorgenommen. Wenn das Rechteckschaltsignal und das Sinussignal sich in Sollphasenlage befinden, ist das Ausgangssignal des Tiefpaßes Null, da in den Zeitintervallen die Anteile des Signals vor und nach dem Nulldurchgang aufintegriert werden und sich gegenseitig aufheben.

In derartigen Phasenvergleichsschaltungen ergibt sich das Problem, daß die während der beiden Halbperioden des Schaltsignals abgegebenen Signale einen Offset aufweisen können. Dieser Offset entsteht dadurch, daß die Bewertung des Sinussignals während der beiden Halbperioden des Schaltsignals nicht in gleicher Weise vorgenommen wird. Die Ursache hierfür liegt meist darin, daß eine Stromspiegelschaltung, die wechselweise im Halbperiodentakt des Schaltsignals an die beiden Gegentaktmischstufen geschaltet wird, nicht exakt arbeitet, d.h. daß deren Ausgangsstrom nicht gleich deren Eingangsstrom ist. Dies führt dann im Ergebnis dazu, daß in dem der Phasenvergleichsschaltung nachgeschalteten Tiefpaß eine Gleichspannungskomponente auftritt, so daß ein Phasenfehler zwischen dem Sinussignal und dem Rechteckschaltsignal auftritt, der oftmals nicht akzeptabel ist.

Dieser Offsetstrom kann zwar durch ein Potentiometer ausgeglichen werden, jedoch ist dazu ein Abgleichvorgang erforderlich.

Die veröffentlichte Patentanmeldung JP-A-61-39605 beschreibt eine Phasenvergleichsschaltung mit einer Doppel-Gegentakt-Mischstufe, einer Stromspiegelschaltung und einer Schalterstufe. Die Schalterstufe dient zur Verminderung des durch die Stromspiegelschaltung erzeugten Phasenfehlers.

Es ist Aufgabe der Erfindung, eine Phasenvergleichsschaltung der eingangs genannten Art anzugeben, welche auch ohne Abgleich ohne Phasenfehler zwischen dem Sinussignal und dem Rechteckschaltsignal arbeitet.

Diese Aufgabe ist erfindungsgemäß dadurch gelöst, daß zwei aktive Stromspiegelschaltungen vorgesehen sind, deren Ausgänge das Phasenvergleichssignal liefern und in denen wenigstens zwei gemeinsame Gegenkopplungsschaltungselemente vorgesehen sind, von denen das erste in der eingangsseitigen Gegenkopplung der ersten Stromspiegelschaltung und in der ausgangsseitigen Gegenkopplung der zweiten Stromspiegelschaltung und das zweite in der ausgangsseitigen Gegenkopplung der ersten Stromspiegelschaltung und der eingangsseitigen Gegenkopplung der zweiten Stromspiegelschaltung wirksam sind und daß die beiden Stromspiegelschaltungen mittels einer Schalterstufe wechselweise im Halbperioden-Takt des Schaltsignals an die beiden Gegentakt-Mischstufen geschaltet werden.

In aktiven Stromspiegelschaltungen, die in der Regel drei Transistoren aufweisen, bestimmt sich das Maß der Genauigkeit vor allem durch die Gegenkopplungsschaltungselemente, die äußerst genau sein müssen. Als Gegenkopplungsschaltungselemente sind dabei im allgemeinen Widerstände vorgesehen. Weichen diese Widerstände auch nur geringfügig voneinander ab, so entsteht das oben beschriebene Problem des Offset-Stroms. Bei der erfindungsgemäßen Phasenvergleichsschaltung sind nun zwei Stromspiegelschaltungen vorgesehen, die wechselweise wirksam sind und mittels einer Schaltstufe im Halbperiodentakt des Schaltsignals an die beiden Gegentaktmischstufen geschaltet werden. Dies bedeutet also z.B., daß während der ersten Halbperiode das Rechteckschaltsignal die erste Stromspiegelschaltung wirksam ist und beispielsweise mit ihrem Eingang an den ersten Gegentakt-Mischer und mit ihrem Ausgang an den zweiten Gegentakt-Mischer geschaltet ist. In diesem Beispiel wäre dann während der zweiten Halbperiode die zweite Stromspiegelschaltung aktiv und mit ihrem Eingang an den zweiten Gegentakt-Mischer und ihrem Ausgang an den ersten Gegentakt-Mischer geschaltet.

Für die beiden Stromspiegelschaltungen sind zwei gemeinsame Gegenkopplungsschaltungselemente, also z.B. Widerstände, vorgesehen. Dabei ist ein solches Gegenkopplungsschaltungselement sowohl für die eingangsseitige Gegenkopplung der einen Stromspiegelschaltung wie auch für die ausgangsseitige Gegenkopplung der anderen Stromspiegelschaltung wirksam. Entsprechendes gilt in umgekehrter Weise für das andere Gegenkopplungsschaltungselement.

Durch diese "kreuzweise" Wirksamkeit der beiden Gegenkopplungsschaltungselemente wird erreicht, daß bei einer Differenz der Widerstandswerte der beiden Gegenkopplungsschaltungselemente, also bei einem während einer Hälfte des Rechteckschaltsignals auftretenden Offset-Strom, während der anderen Periodenhälfte des Rechteckschaltsignals dieser Offset-Strom mit umgekehrtem Vorzeichen auftritt. In einem der Phasenvergleichsschaltung nachgeschalteten Integrator werden diese Offset-Ströme, die gleiche Größe jedoch verschiedenes Vorzeichen haben, ausgemittelt. Auf diese Weise wirken sich Streuungen der Widerstandswerte der beiden Gegenkopplungsschaltungselemente nicht mehr aus und es ist eine sehr viel höhere Genauigkeit eines Phasenregelkreises erzielbar, in der die erfindungsgemäße Phasenvergleichsschaltung eingesetzt werden kann.

Nach einer weiteren Ausgestaltung der Erfindung ist vorgesehen, daß die Schaltstufe zwei Transistoren aufweist, die wechselweise im Halbperioden-Takt des Schaltsignals während einer Halbperiode den Ausgang einer der beiden Gegentakt-Mischstufen auf den Eingang der ersten Stromspiegelschaltung und während der anderen Halbperiode den Ausgang der zweiten Gegentaktmischstufe auf den Eingang der zweiten Stromspiegelschaltung schalten, und daß zwei weitere Transistoren die Ausgänge der Stromspiegelschaltungen jeweils auf den anderen Mischer schalten. Eine solche Schaltstufe, die vorteilhaft auch mittels des Rechteck-Schaltsignals gesteuert sein kann, gestattet trotz einfachen Aufbaus, die beiden Stromspiegelschaltungen in der oben beschriebenen Weise an den Doppelgegentakt-Mischer zu schalten. Da die Ausgänge der beiden Stromspiegelschaltungen miteinander verbunden sind, haben die beiden letztgenannten Transistoren der Schaltstufe die Aufgabe dafür zu sorgen, daß aus Symmetriegründen an den Stromspiegelein- und -ausgängen die selben Umschaltvorgänge stattfinden.

Nach einer weiteren Ausgestaltung der Erfindung ist vorgesehen, daß als Gegenkopplungsschaltungselemente zwei Transistoren vorgesehen sind, deren differentielle Ausgangswiderstände der Kollektor-Emitter-Strecken die ein- bzw. ausgangsseitige Gegenkopplung der Stromspiegelschaltungen bestimmen und deren Basisvorspannung in Abhängigkeit des Rechteckschaltsignals mittels zweier weiterer Transistoren vorgenommen wird, die wechselweise während jeweils einer Periodenhälfte des Schaltsignals die Basisvorspannung liefern.

Diese modifizierte Stromspiegelschaltung in der Phasenvergleichsschaltung weist vor allem den Vorteil auf, daß ihr Ausgangswiderstand bedeutend höher ist, als bei Stromspiegelschaltungen, bei denen als Gegenkopplungsschaltungselemente Widerstände vorgesehen sind. Außerdem ist eine solche Schaltung leichter integrierbar.

Anhand der Zeichnung werden zwei Ausführungsbeispiele der Erfindung näher erläutert. Es zeigen:

Fig. 1 eine erste Ausführungsform der Phasenvergleichsschaltung, bei der als Gegenkopplungsschaltungselemente ohmsche Widerstände vorgesehen sind,

Fig. 2 eine zweite Ausführungsform mit Transistoren als Gegenkopplungsschaltungselemente.

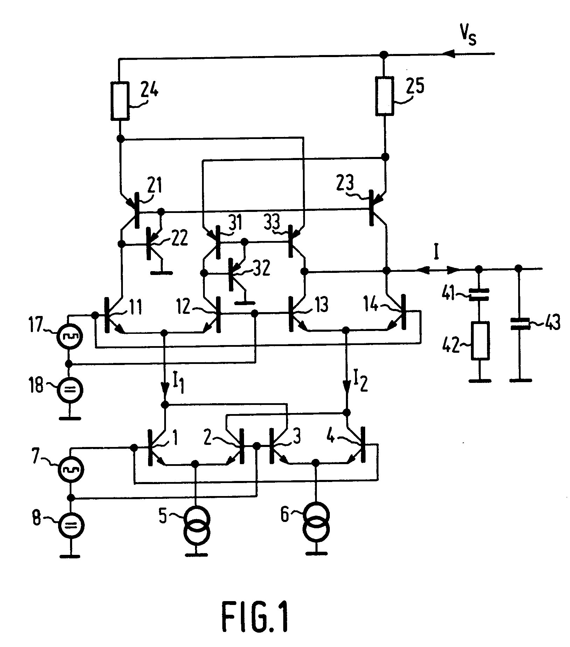

Eine in Fig. 1 dargestellte Phasenvergleichsschaltung ist vorgesehen als Teil eines Phasenregelkreises in einem Stereo-Multiplexdekoder.

Die Phasenvergleichsschaltung weist einen Doppelgegentaktmischer auf, der vier Transistoren 1, 2, 3 und 4 aufweist. Der erste Gegentakt-Mischer, in dem die Transistoren 1 und 2 vorgesehen sind, ist in der Weise aufgebaut, daß die beiden Emitter der Transistoren 1 und 2 mit einer Stromquelle 5 verbunden sind, die ein Sinussignal liefert, in diesem Beispiel das 19 KHz-Pilottonsignal eines FM-Multiplexsignals. Die Emitter der Transistoren 3 und 4 der zweiten Gegentaktmischstufe sind mit einer Stromquelle 6 verbunden, die das gleiche Signal liefert wie die Stromquelle 5, jedoch zu dieser in Gegenphase. Die Basen der Transistoren 1 und 4 sind mit dem einen Pol einer Spannungsquelle 7 verbunden, während die Basen der Transistoren 2 und 3 mit dem anderen Pol dieser Spannungsquelle 7 gekoppelt sind. Die Spannungsquelle 7 liefert ein 19 KHz-Rechteck-Schaltsignal, das aus der Frequenz eines in der Figur nicht dargestellten Phasenregelkreises abgeleitet ist, in der die in der Figur dargestellte Phasenvergleichsschaltung arbeitet.

Die Schaltspannungsquelle 7 ist über eine Gleichspannungsquelle 8 gegen Masse geschaltet, die die für die Transistoren erforderliche Gleichspannung liefert.

Mischer-ausgangsseitig sind die Kollektoren der Transistoren 1 und 3, sowie die Kollektoren der Transistoren 2 und 4 miteinander verbunden. Durch den auf diese Weise gebildeten gemeinsamen Anschluß der Transistoren 1 und 3 fließt ein Strom $I_1$, durch den der Transistoren 2 und 4 ein Strom $I_2$.

Mit diesen beiden Mischerausgängen ist eine Schaltstufe verbunden, welche vier Transistoren 11, 12, 13 und 14 aufweist. Die Emitter der Transistoren 11 und 12 sind auf den den Strom $I_1$ führenden Mischerausgang geschaltet, während die Emitter der Transistoren 13 und 14 auf den den Strom $I_2$ führenden Ausgang des Mischers geschaltet sind. Die Basen der Transistoren 11 und 14 sind auf eine Spannungsquelle 17 geschaltet, welche die gleiche Rechteck-Schaltspannung wie die Spannungsquelle 7 liefert. Die Spannungsquelle 17 wird bei der praktischen Realisation mit der Spannungsquelle 7 übereinstimmen, wobei jedoch eine ausreichende Entkopplung vorgesehen sein muß. Die Spannungsquelle 17 ist über eine Gleichspannungsquelle 18 gegen Masse geschaltet, die die gleiche Aufgabe hat wie die Spannungsquelle 8 in dem Mischer.

Die beiden Transistoren 11 und 14 der Schaltstufe dienen dazu, eine erste Stromspiegelschaltung auf die die Ströme $I_1$ bzw. $I_2$ führenden Anschlüsse des Mischers zu schalten. Dazu ist der Kollektor des Transistors 11 mit dem Kollektor eines Transistors 21 sowie mit der Basis eines Transistors 22 verbunden, die beide Teil einer ersten Stromspiegelschaltung sind. Der Kollektor des Transistors 22 ist auf Masse geschaltet, während der Emitter des Transistors 22 mit der Basis des Transistors 21 sowie mit der Basis eines weiteren Transistors 23 verbunden ist, welcher ebenfalls Bestandteil der ersten Stromspiegelschaltung ist. Der Emitter des Transistors 21 ist über einen Widerstand 24, sowie der Emitter des Transistors 23 über einen Widerstand 25 mit einer Versorgungsspannung verbunden. Die Widerstände 24 und 25 haben den gleichen Widerstandssollwert; Streuungen der tatsächlichen Widerstandswerte sind jedoch in der Praxis nicht zu vermeiden.

Die Transistoren 21, 22, 23 sowie die Widerstände 24 und 25 bilden zusammen die erste Stromspiegelschaltung.

Es ist eine zweite Stromspiegelschaltung vorgesehen, welche drei Transistoren 31, 32 und 33 aufweist, die in entsprechender Weise verschaltet sind wie die Transistoren 21, 22 und 23 der ersten Stromspiegelschaltung. Der Kollektor des Transistors 12 ist dazu mit dem Kollektor des Transistors 31 sowie der Basis des Transistors 32 verbunden, während der Kollektor des Transistors 13 mit dem Kollektor des Transistors 33 verbunden ist. Die zweite Stromspiegelschaltung arbeitet ebenfalls mit den die Gegenkopplung bestimmenden Widerständen 24 und 25. In der zweiten Stromspiegelschaltung ist jedoch der Emitter des Transistors 31 über den Widerstand 25 und der Emitter des Transistors 33 über den Widerstand 24 mit der Versorgungsspannung verbunden.

Diese Verschaltung führt dazu, daß der Widerstand 24 in der ersten Stromspiegelschaltung die eingangsseitige Gegenkopplung bestimmt, während in dieser Stromspiegelschaltung die ausgangsseitige Gegenkopplung vom Widerstand 25 bestimmt wird. In der zweiten Stromspiegelschaltung sind die Widerstände genau umgekehrt wirksam, d.h. also der Widerstand 25 ist für die eingangsseitige Gegenkopplung wirksam, während der Widerstand 24 die ausgangsseitige Gegenkopplung bestimmt.

Die Kollektoren der Transistoren 23 und 33 bilden zusammengeschaltet mit den Kollektoren der Transistoren 13 und 14 den Ausgang der Phasenvergleichsschaltung.

Zusätzlich zu der Phasenvergleichsschaltung ist in der Fig. 1 ein Schleifenfilter eines im übrigen in der Figur nicht dargestellten Phasenregelkreises, das Tiefpaßfilterfunktion hat, dargestellt. Das Schleifenfilter weist eine Reihenschaltung eines Kondensators 41 sowie eines Widerstandes 42, welcher gegen Masse geschaltet ist, sowie eines gegen Masse geschalteten Kondensators 43 auf.

Im folgenden soll die Wirkungsweise der in der Fig. 1 dargestellten Phasenvergleichsschaltung mit dem nachgeschalteten Schleifenfilter erläutert werden:

Während einer ersten Halbperiode der Rechteck-Schaltspannung, die während dieser Zeit positiv ist, sind mittels der Spannungsquellen 7 und 8 die Transistoren 1 und 4 sowie mittels der Spannungsquellen 17 und 18 die Transistoren 11 und 14 leitend geschaltet. Dies hat zur Folge, daß der von der Stromquelle 5 gelieferte Strom, der sinusförmigen Charakter hat, dem Eingang der ersten Stromspiegelschaltung, d.h. also den Transistoren 21 und 22 zugeführt ist. Ebenso sind die Transistoren 4 und 14 leitend geschaltet. Ihnen ist mittels der Stromquelle 6 der gleiche Strom aufgeprägt, der sich jedoch zu dem Strom der Quelle 5 in Gegenphase befindet. Befinden sich die von den Spannungsquellen 7 und 17 einerseits und von den Stromquellen 5 und 6 andererseits gelieferten Signale in Sollphasenlage und setzt man weiterhin voraus, daß die Stromspiegelschaltung korrekt arbeitet, d.h. also am Ausgang exakt den gleichen Strom liefert, der ihr am Eingang zugeführt ist, so fließt sowohl in den beiden Anschlüssen des Mischers, wie auch im Eingang und Ausgang der Stromspiegelschaltung jeweils der gleiche Strom, so daß im zeitlichen Mittel kein Gleichstrom in das Schleifenfilter des in der Figur ansonsten nicht dargestellten Phasenregelkreises fließt.

Es ist hierbei jedoch vorausgesetzt, daß die Widerstände 24 und 25 exakt denselben Widerstandswert haben. Dies wird jedoch, insbesondere bei Serienfertigung derartiger Schaltungsanordnungen, in der Regel nicht der Fall sein. Dies hat dann zur Folge, daß der am Ausgang der Stromspiegelschaltung fließende Strom nicht dem am Eingang fließenden Strom entspricht, d.h. also größer oder kleiner ist. In einer Phasenvergleichsschaltung hat dies zur Folge, daß ein sogenannter Offset-Strom auftritt, da am Ausgang der Stromspiegelschaltung nicht der gleiche Strom fließt, wie in dem entsprechenden Anschluß des Mischers, der den Strom $I_2$ führt. Dieser Ausgleichsstrom fließt durch den Ausgang der Phasenvergleichsschaltung, d.h. also zum Schleifenfilter hin.

Bei Phasenvergleichsschaltungen nach dem Stande der Technik fließt dieser Offset-Strom bei beiden Halbperioden des Rechteck-Schaltsignals, das durch die Spannungsquellen 7 und 17 geliefert wird, mit gleichem Vorzeichen. Dies hat zur Folge, daß der Phasenregelkreis eine Phasenverschiebung zwischen dem Rechteckschaltsignal und dem Sinussignal einstellt, die nicht erwünscht ist.

Bei der in Fig. 1 dargestellten Phasenvergleichsschaltung ist jedoch eine zweite Stromspiegelschaltung vorgesehen, die während der zweiten Halbperiode des Rechteck-Schaltsignals wirksam ist, in der die Spannungsquellen 17 und 7 die Transistoren 2 und 3 des Mischers sowie die Transistoren 12 und 13 der Schaltstufe leitend schalten.

Es ist dann die aus den Transistoren 31, 32, 33 sowie den Widerständen 24 und 25 gebildete Stromspiegelschaltung aktiv. Es ist nun die Stromquelle 6 über den Transistor 3 und den Transistor 12 mit dem Eingang der zweiten Stromspiegelschaltung verbunden, deren Ausgang über den Transistor 13 und den Transistor 2 mit der Stromquelle 5 verbunden ist.

Geht man von dem in der Praxis zu erwartenden Fall aus, daß die Widerstände 24 und 25 nicht exakt gleiche Widerstandswerte aufweisen, so tritt auch während dieser zweiten Halbperiode am Ausgang der Phasenvergleichsschaltung ein Offset-Strom auf. Infolge der Verschaltung der die Gegenkopplung der beiden Stromspiegel bestimmenden Widerstände 24 und 25 tritt dieser Offset-Strom während der zweiten Halbperiode jedoch gegenüber der ersten Halbperiode des Rechteckschaltsignals mit umgekehrtem Vorzeichen auf.

Im folgenden soll kurz erläutert werden, warum dieser Zusammenhang gegeben ist:.

Während der ersten Halbperiode, während der die Transistoren 1, 11, 4 und 14 leitend geschaltet sind, sowie die erste Stromspiegelschaltung mit den Transistoren 21, 22 und 23 wirksam ist, gilt der Zusammenhang

$$I1 * R24 = I2 * R25,$$

wobei R24 bzw. R25 die ohmschen Widerstandswerte der Widerstände 24 und 25 sind. Nach I1 aufgelöst ergibt sich

$$I1 = I2 * R25 : R24.$$

Während der zweiten Hälfte der Periode der Rechteck-Schaltspannung sind die Transistoren 2, 13, 3 und 12 durchgeschaltet und die zweite Stromspiegelschaltung mit den Transistoren 31, 32 und 33 ist aktiv. Es gilt dann der Zusammenhang

$$I1 * R25 = I2 * R24.$$

Es gilt also

$$I1 = I2 * R24 : R25.$$

Definiert man den Offset-Strom $I_{off}$, d.h. also den Strom, der trotz richtiger Phasenlage durch den Ausgang der Phasenvergleichsschaltung fließt, als:

$$I_{off} = I1 - I2,$$

so zeigt diese Rechnung unmittelbar, daß der Offset-Strom während der ersten Hälfte der Schaltspannungsperiode in erster Näherung vom Betrag genauso groß ist wie der Strom während der zweiten Periodenhälfte, jedoch mit entgegengesetztem Vorzeichen. Infolge der Integration der im Halbperioden-Takt mit wechselndem Vorzeichen auftretenden Offset-Ströme in dem nachgeschalteten Schleifenfilter wird der Einfluß der Streuungen der Widerstandswerte der Widerstände 24 und 25 also im zeitlichen Mittel eliminert. Es ergibt sich trotz abweichender Widerstandswerte bei Einsatz der Phasenvergleichsschaltung in einem Phasenregelkreis (PLL) eine korrekte Phasenlage der von den Stromquellen 5 und 6 gelieferten Sinussignale relativ zu den Schaltsignalen der Spannungsquellen 7 und 17.

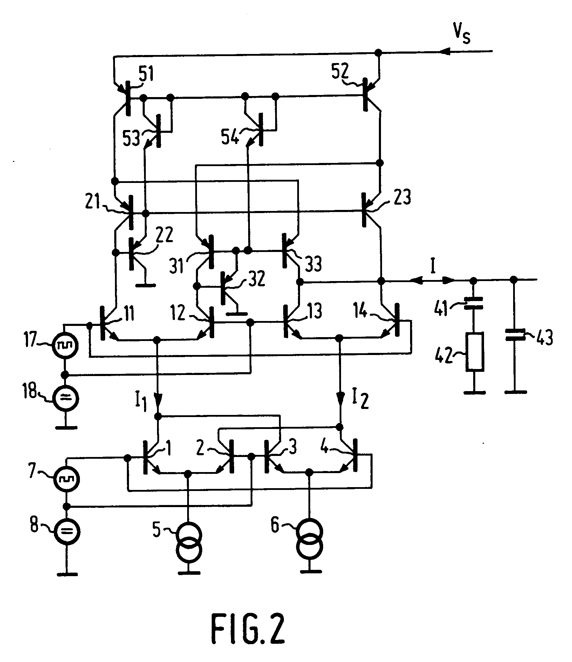

Eine in Fig. 2 dargestellte zweite Ausführungsform der Phasenvergleichsschaltung weist anstelle der Widerstände 24 und 25 der Phasenvergleichsschaltung nach Fig. 1 vier Transistoren 51, 52, 53 und 54 auf, ist ansonsten jedoch in identischer Weise verschaltet wie die Phasenvergleichsschaltung nach Fig. 1.

Es ist dazu der Emitter des Transistors 21 mit dem Kollektor eines Transistors 51 verbunden, dessen Emitter eine Versorgungsspannung zugeführt ist, ebenso wie dem Emitter eines weiteren Transistors 52, dessen Kollektor mit dem Emitter des Transistors 23 verbunden ist. Die Basen der Transistoren 51 und 52 sind miteinander verbunden. Die Basen der beiden Transistoren 51 und 52 sind ferner mit den Basen und den Kollektoren zweier weiterer Transistoren 53 und 54 verbunden. Der Emitter des Transistors 53 ist mit den Basen der Transistoren 21 und 23 und der Emitter des Transistors 54 ist mit den Basen der Transistoren 31 und 33 verbunden.

Die differentiellen Ausgangswiderstände der Kollektor-Emitter-Strecken der Transistoren 51 und 52 bestimmen das Maß der Gegenkopplung der beiden Stromspiegelschaltungen. Es gilt hier ebenso wie für die Widerstände 24 und 25, daß die beiden Transistoren 51 und 52 wechselnd im Halbperiodentakt des Schaltsignals für die beiden Stromspiegelschaltungen in der Weise wirksam sind, daß der die Gegenkopplung bestimmende differentielle Ausgangswiderstand des Transistors 51 für die eingangsseitige Gegenkopplung der ersten Stromspiegelschaltung und für die ausgangsseitige Gegenkopplung der zweiten Stromspiegelschaltung wirksam ist. Umgekehrtes gilt für den differentiellen Ausgangswiderstand des Transistors 52.

Die Basisvorspannung für die beiden Transistoren 51 und 52 wird von den Transistoren 53 und 54 geliefert. Während der ersten Periodenhälfte sind die Transistoren 11 und 14 aktiv, so daß die an der Basis des Transistors 21 anliegende Schaltspannung den Transistor 52 ansteuert. Während der zweiten Periodenhälfte, in der die Transistoren 12 und 13 leitend geschaltet sind, geschieht dies in entsprechender Weise mit dem Transistor 54. Für die Aufintegration eventuell auftretender Offset-Ströme gilt das Gleiche wie für die Schaltung gemäß Fig. 1.

Durch diese modifizierte Stromspiegelschaltung in der Phasenvergleichsschaltung nach Fig. 2 wird darüber hinaus der Vorteil erzielt, daß der Ausgangswiderstand der Phasenvergleichsschaltung an den Kollektoren der Transistoren 23 und 33 bedeutend höher ist als der der in Fig. 1 dargestellten Phasenvergleichsschaltung.

**Patentansprüche**

1. Phasenvergleichsschaltung, insbesondere für einen Phasenregelkreis (PLL) in einem Decoder für Multiplexsignale, mit einer Doppel-Gegentakt-Mischstufe (1-4), der ein Sinussignal, insbesondere der Pilotton eines Multiplexsignals, sowie dieses Sinussignal in Gegenphase und ein Rechteck-Schaltsignal gleicher Schaltfrequenz zugeführt sind, welches insbesondere aus der Frequenz eines Phasenregelkreises abgeleitet ist, dadurch gekennzeichnet, daß zwei aktive Stromspiegelschaltungen (21-25,31-33) vorgesehen sind, deren Ausgänge das Phasenvergleichssignal liefern und in denen wenigstens zwei gemeinsame Gegenkopplungsschaltungselemente (24, 25) vorgesehen sind, von denen das erste (24) in der eingangsseitigen Gegenkopplung der ersten Stromspiegelschaltung (21-25) und in der ausgangsseitigen Gegenkopplung der zweiten Stromspiegelschaltung (31-33,24,25) und das zweite (25) in der ausgangsseitigen Gegenkopplung der ersten Stromspiegelschaltung und der eingangsseitigen Gegenkopplung der zweiten Stromspiegelschaltung wirksam sind und daß die beiden Stromspiegelschaltungen mittels einer Schalterstufe (11-14) wechselweise im Halbperioden-Takt des Schaltsignals an die beiden Gegentakt-Mischstufen geschaltet werden.

2. Phasenvergleichsschaltung nach Anspruch 1, dadurch gekennzeichnet, daß die Schaltstufe zwei Transistoren (11, 12) aufweist, die wechselweise im Halbperioden-Takt des Schaltsignals während einer Halbperiode den Ausgang einer der beiden Gegentakt-Mischstufen auf den Eingang der ersten Stromspiegelschaltung und während der anderen Halbperiode den Ausgang der zweiten Gegentaktmischstufe auf den Eingang der zweiten Stromspiegelschaltung schalten, und daß zwei weitere Transistoren (13, 14) die Ausgänge der Stromspiegelschaltungen auf den jeweils anderen Mischer schalten.

3. Phasenvergleichsschaltung nach Anspruch 1 oder 2, dadurch gekennzeichnet, daß als Gegenkopplungsschaltungselemente zwei ohmsche Widerstände (24, 25) vorgesehen sind.

4. Phasenvergleichsschaltung nach Anspruch 1 oder 2, dadurch gekennzeichnet, daß als Gegenkopplungsschaltungselemente zwei Transistoren (51, 52) vorgesehen sind, deren differentielle Ausgangswiderstände der Kollektor-Emitter-Strecken die ein- bzw. ausgangsseitige Gegenkopplung der Stromspiegelschaltungen bestimmen und deren Basisvorspannung in Abhängigkeit des Rechteckschaltsignals mittels zweier weiterer Transistoren (53, 54) vorgenommen wird, die wechselweise während jeweils einer Periodenhälfte des Schaltsignals die Basisvorspannung liefern.

**Claims**

1. A phase comparison circuit, particularly for a phase-locked loop (PLL) in a decoder for multiplex signals, comprising a double balanced mixer stage (1-4) which receives a sine signal, particularly the pilot of a multiplex signal, as well as said sine signal in anti-phase and a square-wave switching signal of the same switching frequency, which switching signal is derived particularly from the frequency of a phase-locked loop, characterized in that two active current mirror circuits (21-25, 31-33) are provided whose outputs supply the phase comparison signal and in which at least two common negative feedback circuit elements (24, 25) are arranged, the first element (24) being operative in the input-sided negative feedback of the first current mirror circuit (21-25) and in the output-sided negative feedback of the second current mirror circuit (31-33, 24, 25), and the second element (25) being operative in the output-sided negative feedback of the first current mirror circuit and in the input-sided negative feedback of the second current mirror circuit, and in that the two current mirror circuits are alternately connected to the two balanced mixer stages by means of a switching stage (11-14) during the half cycle clock of the switching signal.

2. A phase comparison circuit as claimed in Claim 1, characterized in that the switching stage has two transistors (11, 12) which in the half cycle clock of the switching signal alternately connect the output of one of the two balanced mixer stages to the input of the first current mirror circuit during one half cycle and which connect the output of the second balanced mixer stage to the input of the second current mirror circuit during the other half cycle, and in that two further transistors (13, 14) connect the outputs of the current mirror circuits to the respective other mixer.

3. A phase comparison circuit as claimed in Claim 1 or 2, characterized in that two ohmic resistors (24, 25) are provided as negative feedback circuit elements.

4. A phase comparison circuit as claimed in Claim 1 or 2, characterized in that two transistors (51, 52) are provided as negative feedback circuit elements whose differential output resistances of the collector-emitter paths determine the input-sided and output-sided negative feedback of the current mirror circuits and whose base bias is processed in dependence upon the square-wave switching signal by means of two further transistors (53, 54) which alternately supply the base bias during a respective half cycle of the switching signal.

## Revendications

1. Circuit comparateur de phase, en particulier pour un circuit d'asservissement de phase (PLL) dans un décodeur pour signaux multiplex, comportant un double étage mélangeur symétrique (1-4) qui reçoit un signal sinusoïdal, en particulier le signal pilote d'un signal multiplex, ainsi que ce signal sinusoïdal en opposition de phase et un signal carré de commutation de même fréquence de commutation qui est dérivé, en particulier, de la fréquence d'un circuit d'asservissement de phase, caractérisé en ce que deux miroirs de courant actifs (21-25, 31-33) fournissent à leurs sorties, le signal de comparaison de phase et comprennent au moins deux composants communs (24, 25) de contre-réaction dont le premier (24) agit dans la contre-réaction à l'entrée du premier miroir de courant (21-25) et dans la contre-réaction à la sortie du deuxième miroir de courant (31-33, 24, 25) et le deuxième (25) agit dans la contre-réaction à la sortie du premier miroir de courant et dans la contre-réaction à l'entrée du deuxième miroir de courant et que les deux miroirs de courant sont reliés à tour de rôle, au moyen d'un étage de commutation (11-14), au rythme des alternances du signal de commutation, aux deux étages mélangeurs symétriques.

2. Circuit comparateur de phase suivant la revendication 1, caractérisé en ce que l'étage de commutation comprend deux transistors (11, 12) qui relient à tour de rôle, au rythme des alternances du signal de commutation, pendant une alternance, la sortie de l'un des deux étages mélangeurs symétriques à l'entrée du premier miroir de courant et, pendant l'autre alternance, la sortie du deuxième étage mélangeur symétrique à l'entrée du deuxième miroir de courant, et que deux autres transistors (13, 14) relient les sorties des miroirs de courant à l'autre mélangeur considéré selon le cas.

3. Circuit comparateur de phase suivant la revendication 1 ou 2, caractérisé en ce que les composants de contre-réaction sont deux résistances ohmiques (24, 25).

4. Circuit comparateur de phase suivant la revendication 1 ou 2, caractérisé en ce que les composants de contre-réaction sont deux transistors (51, 52) dont les résistances de sortie différentielles des trajets collecteur-émetteur déterminent la contre-réaction à l'entrée ou à la sortie des miroirs de courant et dont la polarisation de base est assurée en fonction du signal carré de commutation, au moyen de deux autres transistors (53, 54) qui fournissent à tour de rôle la polarisation de base, chacun pendant une alternance du signal de commutation.

FIG.1

FIG.2